(19) **Europäisches Patentamt**

**European Patent Office**

**Office européen des brevets**

(11) **EP 0 821 483 B1**

(12) **EUROPÄISCHE PATENTSCHRIFT**

(45) Veröffentlichungstag und Bekanntmachung des Hinweises auf die Patenterteilung:
**09.11.2005 Patentblatt 2005/45**

(51) Int Cl.⁷: **H03H 19/00**, H03G 5/12

(21) Anmeldenummer: **97112885.5**

(22) Anmeldetag: **25.07.1997**

(54) **SC-Filter mit intrinsischer Anti-Aliasing-Funktion, sowie damit ausgerüsteter Audiosignalprozessor**

SC-filter with intrinsic anti-aliasing function and audio signal processor provided with the same

Filtre à capacités commutées comportant une fonction anti-aliasing intrinsèque et processeur de signaux audio équipé d'un tel filtre

(84) Benannte Vertragsstaaten:
**FR GB IT**

(30) Priorität: **26.07.1996 DE 19630416**

(43) Veröffentlichungstag der Anmeldung:
**28.01.1998 Patentblatt 1998/05**

(73) Patentinhaber: **SGS-THOMSON MICROELECTRONICS GMBH**
**85630 Grasbrunn (DE)**

(72) Erfinder:
• **Lübbe, Jürgen**
**83553 Jacobneuharting (DE)**
• **Kirchlechner, Peter**
**83104 HOHENTHANN (DE)**
• **Schambacher, Jörg**
**81667 München (DE)**

(74) Vertreter: **Hirsch, Peter**
**Klunker Schmitt-Nilson Hirsch**
**Winzererstrasse 106**
**80797 München (DE)**

(56) Entgegenhaltungen:
WO-A-95/13655              FR-A- 2 357 103
GB-A- 2 138 231

**Beschreibung**

Die Erfindung betrifft ein SC-Filter mit intrinsischer Anti-Aliasing-Funktion sowie einen mit einem derartigen Filter ausgestatteten Audiosignalprozessor.

In der GB 2 138 231 A ist eine Filterschaltung mit einem in seinem Frequenzgang einstellbaren SC-Filter beschrieben, bei der in einer neutralen Einstellung der wirksame Audiosignalpfad das SC-Filter umgeht, so daß keine Absenkung oder Anhebung der Amplitude einzelner Frequenzbereiche erfolgt. Ferner ist es aus der GB 2 159 014 A bekannt, einem SC-Filter ein Anti-Alias-Filter vorzuschalten.

Bei Geräten aus dem Bereich der Unterhaltungselektronik, wie beispielsweise Rundfunkempfangsgeräten, Kassettenrecordern, CD-Abspielgeräten u.ä., ist es üblich, im Audio-Signalpfad einstellbare Filterschaltungen vorzusehen, mit denen der Benutzer gewisse Klangcharakteristika wie beispielsweise Höhenanhebung und Höhenbedämpfung oder Bassanhebung und Bassbedämpfung beeinflussen kann. Die Einstellung geeigneter Filterkennwerte erfolgt durch den Bediener mittels dafür vorgesehener Bedienelemente. Die einstellbaren Filterschaltungen sind dabei für Zwecke der Audiosignalbeeinflussung in Geräten der Unterhaltungselektronik regelmäßig derart ausgelegt, daß sie insbesondere auch eine neutrale Einstellung ermöglichen, in welcher sie die Audiosignale hinsichtlich Frequenz- und Phasengang möglichst wenig beeinflussen. Wenn der Bediener keinerlei Anhebung oder Absenkung von bestimmten Frequenzbereichen des Audiosignals wünscht, wird er diese neutrale Einstellung der jeweiligen Filterschaltung wählen.

Im Hinblick auf zahlreiche der Unterhaltungselektronik zuzurechnende Geräte, so zum Beispiel bei kompakten Rundfunkempfangsgeräten, wie sie insbesondere bei der Ausrüstung von Kraftfahrzeugen Verwendung finden, ist seit langem ein Trend zu beobachten, zur Kostensenkung bei der Herstellung die gesamte elektrische Schaltung des Empfängers aus möglichst wenigen hochintegrierten elektronischen Bausteinen zusammenzufügen.

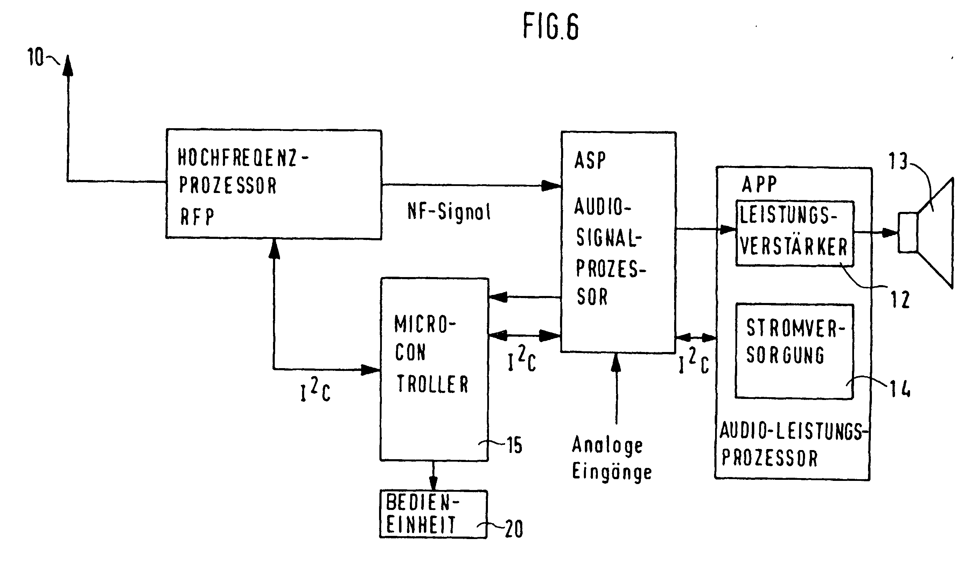

**Fig. 6** zeigt ein Blockschaltbild eines Rundfunkempfangsgerätes nach dem Stand der Technik. Die von einer Hochfrequenzantenne 10 gelieferten Hochfrequenzsignale werden einem Hochfrequenz-Empfangsteil, im folgenden Text "Hochfrequenzprozessor" RFP genannt, zugeführt. Der Hochfrequenzprozessor RFP beinhaltet Hochfrequenz-Vorstufen, Tuner, Zwischenfrequenzverstärker und -Filter sowie Demodulatoren. Ein das Nutzsignal des empfangenen Senders darstellendes Niederfrequenzsignal wird einem Audiosignalprozessor ASP zugeführt. Dieses Niederfrequenzsignal umfaßt nicht nur das demodulierte Audiosignal, sondern auch Hilfssignale für Stereo-Empfang, ARI-Kennung, RDS und andere.

Der Audiosignalprozessor ASP setzt insbesondere das vom Hochfrequenzprozessor RFP gelieferte Niederfrequenzsignal in Audiosignale um, die einem Audio-Leistungsprozessor APP zugeführt werden. Der Audio-Leistungsprozessor APP umfaßt insbesondere einen Leistungsverstärker 12, der die vom Audio-Signalprozessor ASP gelieferten Ausgangssignale soweit verstärkt, daß sie durch Lautsprecher 13 wiedergegeben werden können. Ferner umfaßt der Audio-Leistungsprozessor APP ein Spannungsreglermodul 14 zur Stromversorgung.

Dem Audiosignalprozessor ASP können über weitere analoge Eingänge andere Audiosignale, beispielsweise von Kassettenrecordern, CD-Abspielgeräten o. dgl., zugespeist werden.

Das beschriebene Rundfunkempfangsgerät wird als Ganzes durch einen Mikrocontroller 15, der mit einer dem Bediener zugänglichen Bedieneinheit 20 ausgestattet ist, gesteuert. Der Datenaustausch zwischen dem Mikrocontroller 15 einerseits und dem Hochfrequenzprozessor RFP, dem Audiosignalprozessor ASP und dem Audio-Leistungsprozessor APP andererseits erfolgt durch einen herkömmlichen I$^2$C-Bus.

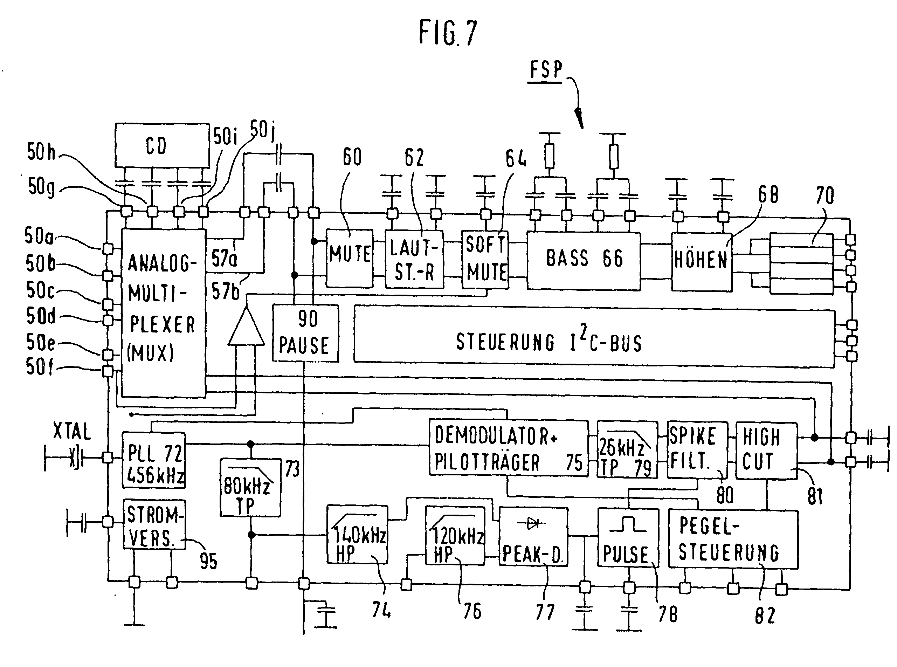

**Fig. 7** zeigt ein schematisches Blockschaltbild des integrierten Audiosignalprozessors ASP des in **Fig. 6** dargestellten Rundfunkempfängers. Der Audiosignalprozessor ASP weist eine Anzahl von analogen Audiosignaleingängen 50a bis 50j auf, die mit entsprechenden Eingangsleitungen eines Analog-Multiplexers 55 verbunden sind. Ein Stereo-Ausgangssignal des Analog-Multiplexers 55 wird über Ausgangsleitungen 57a und 57b einer Kette aus hintereinander geschalteten und als Signalbehandlungsvorrichtungen wirkenden Blöcken 60, 62, 64, 66, 68 zugespeist.

Zunächst gelangen die Audiosignale in ein Stummschaltungsfilter ("Mute") 60, danach nacheinander in einen Lautstärkeregler mit Loudness-Filter 62, in eine zweite Stummschaltungsanordnung mit weicher Stummschaltungseigenschaft ("Soft Mute") 64, einen Tiefenregler ("Bass") 66 sowie einen Höhenregler 68 ("Treble"). Danach werden die Stereo-Audiosignale einer Anzahl von Audiotreiberverstärkern 70 zugespeist, wo sie soweit konditioniert werden, daß sie für die Ansteuerung der Leistungsendstufen im Leistungsverstärker 12 innerhalb des Audio-Leistungsprozessors APP geeignet sind.

Dabei wird jeder Kanal des Stereosignals in einen ersten Unterkanal für einen vorn in der Fahrgastzelle anzubringenden ersten Lautsprecher und einen zweiten Unterkanal für einen hinten im Fahrgastraum anzubringenden zweiten Lautsprecher aufgeteilt.

Ferner weist der Audiosignalprozessor eine Reihe von üblichen Funktionsblöcken 72 bis 82 auf, die zur Verarbeitung des Stereo-Differenzsignals, des ARI-Signals usw. erforderlich sind. Schließlich ist eine Pausenschaltung 90 und eine Stromversorgungseinrichtung 95 vorgesehen.

Dem Fachmann ist deutlich, daß der in den **Fign. 6** und **7** wiedergegebene Audiosignalprozessor ASP nicht die einzige mögliche Ausführungsform eines solchen Prozessors darstellt. Insbesondere kann der Audiosignalprozessor ASP auch ohne die Funktionseinheiten zur Behandlung von FM-Stereosignalen implementiert sein. Auch die Art und Anzahl der NF-Stufen zur Beeinflussung des Audiosignals kann im Einzelfall variieren.

Die vorstehend beschriebene Schaltung weist den Nachteil auf, daß eine vollständige Integration der Audiofilter 62, 66, 68 nicht gegeben ist, da zahlreiche RC-Glieder mit hohen Widerstandswerten wegen zu großen Chipflächenbedarfes der Widerstände R mittels externer Bauelemente realisiert sind.

Bei Anwendung der sogenannten "Switched Capacitor"-Filtertechnik ("SC-Technik") werden große Widerstandswerte, die bei direkter Implementation einen großen Verbrauch an Chipfläche verursachen würden, durch Anordnungen mit geschalteten Kondensatoren substituiert. Filterschaltungen mit geschalteten Kondensatoren als solche sind beispielsweise aus "Analog MOS Integrated Circuits for Signal Processing" von Roubik Gregorian und Gabor C. Temes, John Wiley & Sons, bekannt. Diese Schaltungstechnik erleichtert zwar die vollständige Integration von Filterschaltungen auf einem Halbleiterchip, zieht jedoch auch andere Folgeprobleme nach sich.

Bei der "switched capacitor"-Filtertechnik werden die Nutzsignale faktisch mit der Frequenz, bei der zur Umspeicherung von Ladungen verwendete Kondensatoren geschaltet werden, abgetastet. Nach dem grundlegenden Abtasttheorem von Shannon wird ein analoges Signal s(t) durch äquidistante Abtastwerte im zeitlichen Abstand $\Delta t$ nur dann vollständig beschrieben, wenn das Frequenzspektrum von s(t) oberhalb einer oberen Grenzfrequenz $f_{max}$ identisch Null ist:

$$f_{max} = \frac{1}{2\Delta t} \qquad (1)$$

Somit beträgt die obere nutzbare Grenzfrequenz die Hälfte der Abtastfrequenz, und Signalanteile höherer Frequenzen oberhalb $f_{max}$ führen zum sogenannten "Aliasing-Effekt", d.h., der Energiegehalt dieser höherfrequenten Signalanteile tritt im Basisband in Gestalt von Störsignalen auf. Die Grundlagen des Aliasing-Effektes sind beispielsweise aus "Nachrichtentechnik", Band II: "Nachrichtenübertragung", von W. Rupprecht, Springer-Verlag, Berlin u.a., 1982, Seiten 75 bis 78, bekannt.

Ein herkömmliches Gegenmittel gegen diesen Aliasing-Effekt besteht darin, vor einer in "Switched Capacitor"-Technik realisierten Filterkette einen Eingangs-Tiefpaß anzuordnen, dessen Kennwerte in geeigneter Weise so gewählt werden, daß Signalanteile mit Frequenzen größer als $f_{max}$ hinreichend stark bedämpft werden.

Diese Schaltungstechnik hat jedoch den Nachteil, daß das Eigenrauschen und Verzerrungen des Eingangs-Tiefpaßfilters auch dann sich dem Nutzsignal überlagern, wenn das Filter bzw. die Filterkette sich in der neutralen Einstellung befinden.

Aufgabe der Erfindung ist es daher, ein einstellbares SC-Filter mit Anti-Alias-Funktion sowie einen mit einem derartigen Filter ausgestatteten Audiosignalprozessor vorzusehen, die die Nachteile bei dem Stand der Technik nicht aufweisen und die insbesondere leicht vollständig integrierbar und auch in der neutralen Stellung rausch- und verzerrungsarm sind.

Diese Aufgabe wird erfindungsgemäß gelöst durch ein SC-Filter gemäß Anspruch 1 sowie durch einen Audiosignalprozessor gemäß Anspruch 17. Den Unteransprüchen sind Weiterbildungen der Gegenstände der unabhängigen Ansprüche entnehmbar.

Die Erfindung wird im folgenden anhand von Ausführungsbeispielen unter Bezugnahme auf die Zeichnung näher erläutert:

**Fig. 1** zeigt ein Blockschaltbild eines erfindungsgemäßen, in SC-Technik ausgeführten einstellbaren Audio-SC-Filters mit intrinsischer Anti-Alias-Funktion.

**Fig. 2** zeigt in **Fig. 2a** eine Schemadarstellung eines als geschalteter Kondensator ausgeführten Widerstandselementes 200 und in **Fig. 2b** ein Äquivalentschaltbild dieses Widerstandselementes 200. **Fig. 2c** zeigt eine exemplarische Implementation einer Umschalteinrichtung aus **Fig. 2b** unter Verwendung von zwei MOS-Transistoren. **Fig. 2d** zeigt überlappungsfreie Taktsignale.

**Fig. 3** zeigt ein Schaltungsdiagramm einer ersten Ausführungsform des Filtermoduls mit Anti-Alias-Tiefpaß aus **Fig. 1**, nämlich für ein Loudness-Filter.

**Fig. 4** zeigt eine zweite Ausführungsform des Filtermoduls mit Anti-Alias-Tiefpaß aus **Fig. 1**, nämlich für ein Bass-Filter.

**Fig. 5** zeigt ein Schaltungsdiagramm einer dritten Ausführungsform des Filtermoduls mit Anti-Alias-Tiefpaß aus **Fig. 1**, nämlich für ein Treble-Filter.

**Fig. 6** zeigt ein schematisches Blockschaltbild eines Rundfunkempfangsgerätes nach dem Stand der Technik.

**Fig. 7** zeigt ein schematisches Blockschaltbild des Audiosignalprozessors des Rundfunkempfangsgerätes aus **Fig. 4** mit einiger peripherer Beschaltung.

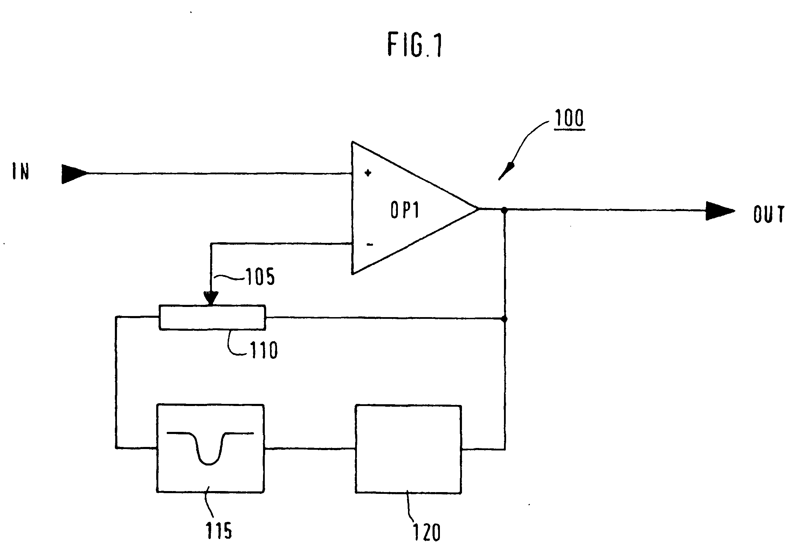

**Fig. 1** zeigt ein Blockschaltbild eines erfindungsgemäßen, in SC-Technik ausgeführten einstellbaren Audio-Filters 100 mit intrinsischer Anti-Alias-Funktion, das insbesondere zum Einsatz in einem Audiosignalprozessor ASP geeignet ist, wie er beispielsweise in **Fig. 7** veranschaulicht wird. Die in **Fig. 1** dargestellte Schaltung ist dann insbesondere zur Implementation des Loudness-Filters 62, des Bass-Filters 66 sowie des Treble-Filters 68 geeignet.

Die Schaltung weist einen Eingang IN, der mit dem nicht invertierenden Eingang eines Operationsverstärkers OP1 verbunden ist, sowie einen Ausgang OUT, der mit dessen Ausgang verbunden ist, auf. Der invertierende Eingang des Operationsverstärkers OP1 ist mit dem Abgriff 105 eines zwischen den Ausgang des Operationsverstärkers OP1 und den Ausgang eines in SC-Technik realisierten Filtermoduls 115 geschalteten ohmschen Spannungsteilers 110 verbunden. Der Eingang des Filtermoduls 115 ist über einen Anti-Alias-Tiefpaß 120 mit dem Ausgang des Operationsverstärkers OP1 verbunden.

Die Einstellung des Abgriffes 105 des ohmschen Spannungsteilers 110 bestimmt die Wirksamkeit des in **Fig. 1** dargestellten erfindungsgemäß geschalteten Filters mit Anti-Aliasing. Wird der Abgriff 105 des ohmschen Spannungsteilers 110 so eingestellt, daß er unmittelbar mit dem Ausgang des Operationsverstärkers OP1 kurzgeschlossen ist, so verhält sich die in **Fig. 1** dargestellte Schaltung wie ein Spannungsfolger mit dem Verstärkungsfaktor gleich Eins. Das Filtermodul 115 wie auch der Anti-Alias-Tiefpaß 120 liegen nicht im Signalpfad. In diesem Fall befindet sich das Filter 100 in seiner neutralen Einstellung, und weder das Filtermodul 115 noch der Anti-Alias-Tiefpaß 120 speisen Rauschspannungen in das Audio-Ausgangssignal an der Ausgangsklemme OUT ein oder verursachen Signalverzerrungen.

In dem Maße, in dem der Abgriff 105 des ohmschen Spannungsteilers 110 in seiner Einstellung so verändert wird, daß ein Teilwiderstand zwischen dem Ausgang des Operationsverstärkers OP1 und dem Abgriff 105 wirksam wird, geraten das Filtermodul 115 sowie der Anti-Alias-Tiefpaß 120 in den Signalpfad und beeinflussen die Frequenzcharakteristik des Filters.

Dabei wird das Ausgangssignal am Ausgangsanschluß des Operationsverstärkers OP1 über den Anti-Alias-Tiefpaß 120, über das Filtermodul 115 sowie über den Spannungsteiler 110 auf den invertierenden Eingang des Operationsverstärkers OP1 gegengekoppelt. Der Anti-Alias-Tiefpaß 120 verhindert, daß Signalanteile einer Frequenz größer als der Maximalfrequenz $f_{max}$, d.h. der Hälfte der Schaltfrequenz geschalteter Kondensatoren innerhalb des Filtermoduls 115, auf den Eingang des Filtermoduls 115 gelangen können.

Der Anti-Alias-Tiefpaß 120 kann insbesondere als herkömmlicher RC-Tiefpaß ausgeführt werden. Es ist auch möglich, die Funktionen des Anti-Alias-Tiefpasses 120 sowie des Filtermoduls 115 in einer komplexen Filterschaltung zusammenzufassen.

Der ohmsche Spannungsteiler 110 kann als herkömmliches Potentiometer ausgeführt werden. Bei einem Einsatz in einer integrierten Schaltung erweist es sich jedoch als vorteilhaft, den ohmschen Spannungsteiler 110 beispielsweise als mit MOS-Schaltern geschaltete Widerstandskette auszuführen. Beim Einsatz der Filterschaltung nach **Fig. 1** in einem Audiosignalprozessor (wie beispielsweise in **Fig. 7** dargestellt) besteht dann die Möglichkeit, den ohmschen Spannungsteiler 110 durch eine digitale Einstelleinrichtung z.B. über den I²C - Bus einzustellen.

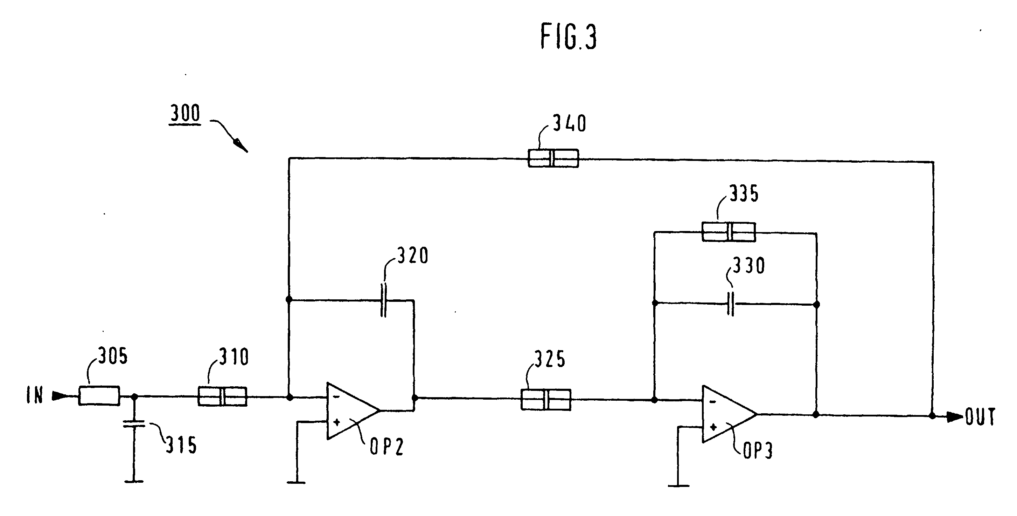

**Fig. 2a** zeigt eine schematische Darstellung eines mit einem geschalteten Kondensator implementierten Widerstandselementes 200, wie es in den in den **Fign. 3** bis **5** dargestellten Ausführungsformen verwendet wird.

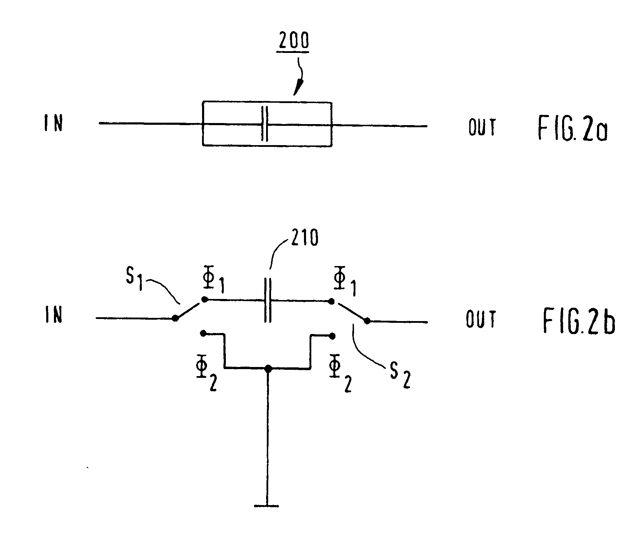

**Fig. 2b** zeigt ein elektrisches Äquivalentschaltbild des in **Fig. 2a** dargestellten Widerstandselementes 200. Der Eingang IN der Schaltung kann über eine erste Umschalteinrichtung S1 mit einem ersten Anschluß eines Kondensators 210 oder aber mit Masse verbunden werden. Der Ausgangsanschluß OUT kann über eine zweite Umschalteinrichtung S2 mit einem zweiten Anschluß des Kondensators 210 oder mit Masse verbunden werden. Wenn die Umschalteinrichtungen S1, S2 nicht angesteuert werden, sind sie elektrisch offen.

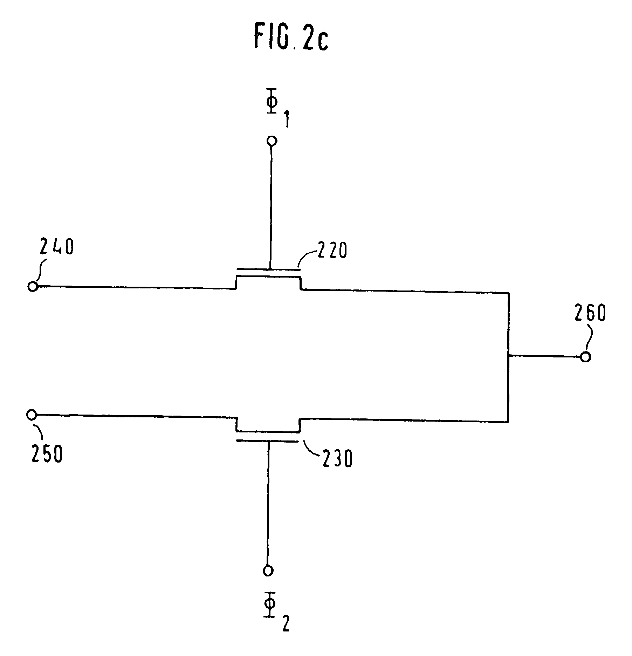

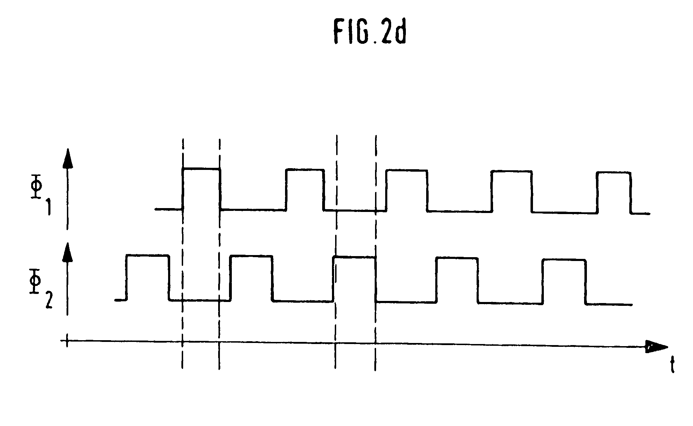

**Fig. 2c** zeigt eine exemplarische Implementation einer Umschalteinrichtung S1, S2 aus **Fig. 2b** unter Verwendung von zwei MOS-Transistoren 220, 230. Ein erster MOS-Transistor 220 verbindet über seine Source-Drain-Strecke einen gemeinsamen Anschluß 260 mit einem ersten Umschalter-Ausgangsanschluß 240, wohingegen ein zweiter MOS-Transistor 230 über seine Source-Drain-Strecke den gemeinsamen Anschluß 260 mit einem zweiten Umschalter-Ausgangsanschluß 250 verbindet. Das Gate des ersten MOS-Transistors 220 ist an das Taktsignal $\Phi_1$ angeschlossen, wohingegen das Gate des zweiten MOS-Transistors 230 an das Taktsignal $\Phi_2$ angeschlossen ist. **Fig. 2d** zeigt Taktsignale $\Phi_1$, $\Phi_2$ zur Ansteuerung der Umschalteinrichtungen S1, S2 in **Fig. 2b** bzw. der MOS-Transistoren 220, 230 in **Fig. 2c**. Wie in der SC-Technik üblich, sind die beiden Taktphasen $\Phi_1$, $\Phi_2$ derart ausgestaltet, daß sich ihre hochpegeligen (aktiven) Intervalle zu keinem Zeitpunkt überlappen. Dadurch wird erreicht, daß in der Schaltung nach **Fig. 2c** stets nur ein einziger der beiden MOS-Transistoren 220, 230 leitet und somit der gemeinsame Anschluß 260 offen ist oder entweder mit dem ersten Umschalteranschluß 240 oder mit dem zweiten Umschalteranschluß 250, nie jedoch mit beiden gleichzeitig, verbunden ist.

**Fig. 3** zeigt ein elektrisches Schaltungsdiagramm einer ersten Ausführungsform 300 eines Filtermoduls 115, nämlich für ein Loudness-Filter mit Anti-Alias-Eigenschaft, das die Funktionsblöcke des Filtermoduls 115 sowie des Anti-Alias-Tiefpasses 120 aus **Fig. 1** in sich vereinigt.

Die Schaltung verkörpert einen Tiefpaß II. Ordnung und ist in SC-Technik ausgeführt.

Ein Eingang IN ist über einen ersten Tiefpaßwiderstand 305 und einen ersten in SC-Technik ausgeführten Widerstand 310 mit dem invertierenden Eingang eines Operationsverstärkers OP2 verbunden. Der zweite Anschluß des ersten Tiefpaßwiderstandes 305, der nicht mit dem Eingangsanschluß IN verbunden ist, ist über eine erste Tiefpaßkapazität 315 mit Masse verbunden. Der nicht-invertierende Eingang des Operationsverstärkers OP2 ist mit Masse verbunden.

Der Ausgang des Operationsverstärkers OP2 ist über eine Kapazität 320 mit dessen invertierendem Eingang verbunden. Der invertierende Eingang eines weiteren Operationsverstärkers OP3 ist über einen zweiten in SC-Technik ausgeführten Widerstand 325 mit dem Ausgang des Operationsverstärkers OP2 verbunden. Der nicht-invertierende Eingang des Operationsverstärkers OP3 ist ebenfalls mit Masse verbunden.

Der Ausgang des Operationsverstärkers OP3 ist über einen dritten Kondensator 330 mit dessen invertierendem Eingang verbunden. Parallel zu der dritten Kapazität 330 ist ein dritter in SC-Technik ausgeführter Widerstand 335 geschaltet. Ein vierter in SC-Technik ausgeführter Widerstand 340 verbindet den invertierenden Eingang des Operationsverstärkers OP2 mit dem Ausgang des Operationsverstärkers OP3.

Der Ausgang des Operationsverstärkers OP3 ist mit einem Ausgang OUT verbunden.

Der Widerstand 305 sowie die Kapazität 315 bilden den Anti-Alias-Tiefpaß 120 in **Fig. 1**. Der Operationsverstärker OP2 sowie der Operationsverstärker OP3 sowie die übrigen Bauelemente entsprechen dem Filtermodul 115 in **Fig. 1**.

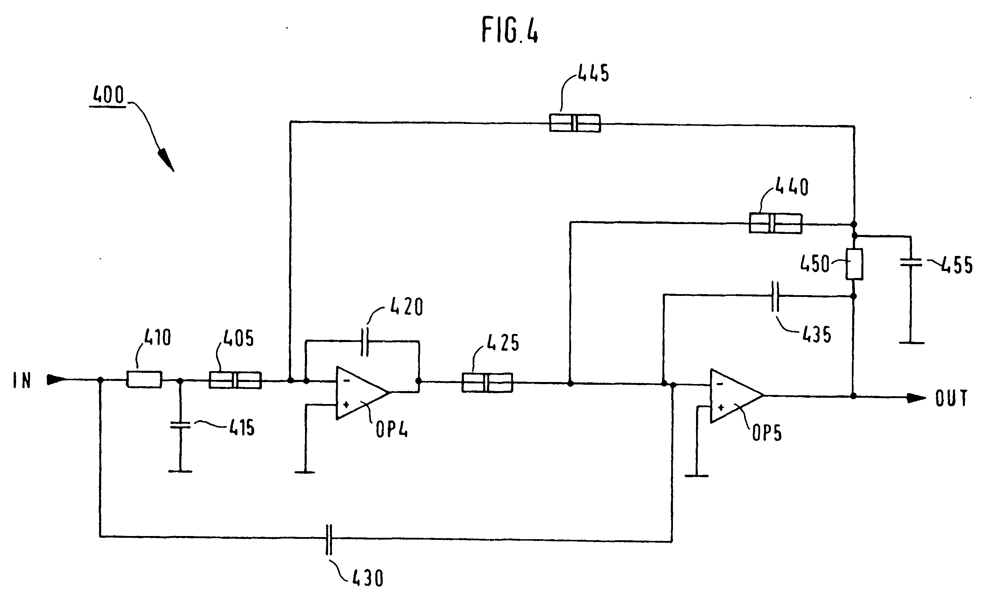

**Fig. 4** zeigt ein elektrisches Schaltungsdiagramm einer zweiten Ausführungsform 400 eines Filtermoduls 115 mit Anti-Alias-Tiefpaß. Die in **Fig. 4** dargestellte Schaltung kommt in einem Bass-Filter zum Einsatz.

Der invertierende Eingang eines Operationsverstärkers OP4 ist über einen ersten in SC-Technik ausgeführten Widerstand 405 sowie über einen ersten Tiefpaßwiderstand 410 mit einem Eingang IN verbunden. Der Anschluß des Tiefpaßwiderstandes 410, der nicht mit dem Eingangsanschluß IN verbunden ist, ist über eine erste Tiefpaßkapazität 415 an Masse geschaltet. Der nicht-invertierende Eingang des Operationsverstärkers OP4 ist ebenfalls mit Masse verbunden. Der Ausgang des Operationsverstärkers OP4 ist über eine erste Filterkapazität 420 mit dessen invertierendem Eingang verbunden. Der invertierende Eingang eines weiteren Operationsverstärkers OP5 ist über einen zweiten in SC-Technik ausgeführten Widerstand 425 mit dem Ausgang des Operationsverstärkers OP4 verbunden. Der invertierende Eingang des Operationsverstärkers OP5 ist außerdem über eine zweite Filterkapazität 430 mit dem Eingang IN sowie über eine dritte Filterkapazität 435 mit dem Ausgang des Operationsverstärkers OP5 verbunden. Schließlich ist der invertierende Eingang des Operationsverstärkers OP5 über einen dritten in SC-Technik ausgeführten Widerstand 440 und einen vierten in SC-Technik ausgeführten Widerstand 445 mit dem invertierenden Eingang des Operationsverstärkers OP4 verbunden.

Der nicht mit dem invertierenden Eingang des Operationsverstärkers OP5 verbundene Anschluß des dritten in SC-Technik ausgeführten Widerstandes 440 sowie der nicht mit dem invertierenden Eingang des Operationsverstärkers OP5 verbundene Anschluß der dritten Filterkapazität 435 sind über einen zweiten Tiefpaßwiderstand 450 miteinander verbunden. Der Verbindungsknoten zwischen den in SC-Technik ausgeführten Widerständen 440 und 445 ist über eine zweite Tiefpaßkapazität 455 an Masse geschaltet. Der Ausgang des Operationsverstärkers OP5 ist mit dem Ausgangsanschluß OUT verbunden.

Die Filterschaltung 400 stellt ein modifiziertes Biquad-Filter dar. Die RC-Glieder 410, 415 sowie 450, 455 entsprechen dem Anti-Alias-Tiefpaß 120 in **Fig. 1**, wohingegen alle übrigen Bauelemente einschließlich den beiden Operationsverstärkern OP4 und OP5 dem Filtermodul 115 in **Fig. 1** entsprechen.

Der erste Tiefpaß 410, 415 filtert höherfrequente Signalanteile vor dem ersten in SC-Technik ausgeführten Widerstand 405 aus.

Über die Kapazität 430 können dennoch höherfrequente Signalanteile zum invertierenden Eingang des Operationsverstärkers OP5 und von dort zu den in SC-Technik ausgeführten Widerständen 440, 445 gelangen. Um diese höherfrequenten Signalanteile auch dort zu unterdrücken, ist ein zweiter Tiefpaß 450, 455 vorgesehen.

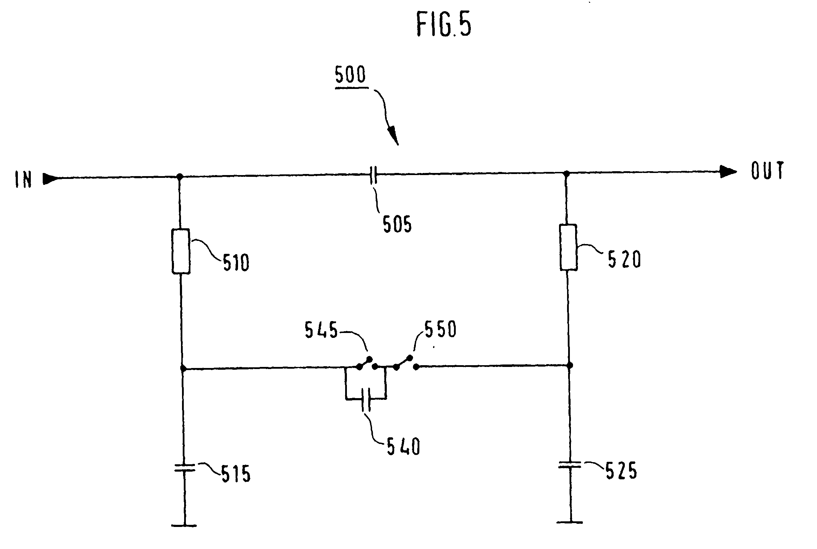

**Fig. 5** zeigt ein elektrisches Schaltungsdiagramm einer dritten Ausführungsform 500 eines Filtermoduls 115, nämlich für ein Treble-Filter. Ein Eingang IN ist über eine erste Kapazität 505 mit einem Ausgang OUT verbunden. Des weiteren ist der Eingang IN über einen ersten Widerstand 510 und eine zweite Kapazität 515 an Masse geschaltet. Der Ausgangsanschluß OUT ist über einen zweiten Widerstand 520 und eine dritte Kapazität 525 ebenfalls an Masse geschaltet. Die Kopplungspunkte zwischen dem Widerstand 510 und der Kapazität 515 sowie dem Widerstand 520 und der Kapazität 525 sind über einen in SC-Technik ausgeführten Widerstand 530 miteinander verbunden.

Die in **Fig. 5** dargestellte Schaltung entspricht den Funktionsblöcken des Filtermoduls 115 sowie des Anti-Alias-Tiefpasses 120 in **Fig. 1**.

Mit der in **Fig. 5** dargestellten Schaltung läßt sich über dem SC-Widerstand ein frequenzabhängiger Spannungsabfall dritter Ordnung entsprechend etwa 60 Dezibel pro Dekade erzielen.

**Patentansprüche**

1.  SC-Filter zum einstellbaren Absenken oder Anheben der Amplitude von Audiosignalen in einem vorbestimmten Frequenzbereich,

a) mit einem Filtermodul (115), wobei das Filtermodul ein RC-Netzwerk mit mindestens einem frequenzgangbestimmenden RC-Glied aufweist, dessen Widerstandskomponente R in SC-Technik realisiert ist,

b) mit einer Einstelleinrichtung (110), die derart mit dem Filtermodul (115) verschaltet ist, daß deren Einstellung den Frequenzgang des SC-Filters festlegt,

c) wobei die Einstelleinrichtung (110) insbesondere auch eine neutrale Einstellung ermöglicht, in der der wirksame Audiosignalpfad des SC-Filters das Filtermodul (115) umgeht, so daß keine Absenkung oder Anhebung der Amplitude einzelner Frequenzbereiche erfolgt, **gekennzeichnet durch**

d) eine in den Audiosignalpfad geschaltete Anti-Alias-Tiefpaßfiltereinheit (120),

e) wobei die Anti-Alias-Tiefpaßfiltereinheit (120) nicht im Audiosignalpfad liegt, wenn die Einstelleinrichtung (110) in der neutralen Stellung eingestellt ist.

2. SC-Filter nach Anspruch 1, **dadurch gekennzeichnet, daß** die Einstelleinrichtung (110) ein ohmscher Spannungsteiler ist.

3. SC-Filter nach Anspruch 2, **dadurch gekennzeichnet, daß** die Einstelleinrichtung (110) ein Potentiometer aufweist.

4. SC-Filter nach Anspruch 2, **dadurch gekennzeichnet, daß** die Einstelleinrichtung (110) mit einem einen oder mehrere Transistoren aufweisenden Spannungsteiler versehen ist.

5. SC-Filter nach einem der Ansprüche 2, 3 oder 4, **dadurch gekennzeichnet, daß** das Filtermodul (115) und die Anti-Alias-Tiefpaßfiltereinheit (120) in Reihe geschaltet sind und der Gesamtwiderstand des ohmschen Spannungsteilers (110) parallel zu der Reihenschaltung von Filtermodul (115) und Anti-Alias-Tiefpaßfiltereinheit (120) geschaltet ist.

6. SC-Filter nach Anspruch 5, **gekennzeichnet durch**

a) einen ersten Operationsverstärker (OP1),

b) wobei der Abgriff (105) des ohmschen Spannungsteilers (110) mit dem invertierenden Eingang des ersten Operationsverstärkers (OP1) verbunden ist und

c) wobei der Eingang der Anti-Alias-Tiefpaßfiltereinheit (120) mit dem Ausgang des ersten Operationsverstärkers (OP1) verbunden ist.

7. SC-Filter nach einem der Ansprüche 1 bis 6,

a) mit einem Eingang (IN) und einem Ausgang (OUT),

b) mit einem ersten Operationsverstärker (OP1), wobei der nicht-invertierende Eingang des ersten Operationsverstärkers (OP1) mit dem Eingang (IN) und der Ausgang des ersten Operationsverstärkers (OP1) mit dem Ausgang (OUT) verbunden ist,

c) mit einem ohmschen Spannungsteiler (110), dessen Abgriff (105) mit dem invertierenden Eingang des ersten Operationsverstärkers (OP1) verbunden ist,

d) wobei der Ausgang des ersten Operationsverstärkers (OP1) mit dem Eingang der Anti-Alias-Tiefpaßfiltereinheit (120) sowie mit einem ersten Endanschluß des ohmschen Spannungsteilers (110) verbunden ist,

e) wobei der Ausgang der Anti-Alias-Tiefpaßfiltereinheit (120) mit dem Eingang des Filtermoduls (115) verbunden ist, und

f) wobei der Ausgang des Filtermoduls (115) mit einem zweiten Endanschluß des ohmschen Spannungsteilers (110) verbunden ist.

8. SC-Filter nach einem der vorstehenden Ansprüche, **dadurch gekennzeichnet, daß** die Anti-Alias-Tiefpaßfiltereinheit (120) ein RC-Tiefpaß ist.

9. SC-Filter nach einem der vorstehenden Ansprüche, **dadurch gekennzeichnet, daß** das Filtermodul (115) ein Biquad-Filter aufweist.

10. SC-Filter nach Anspruch 9, **dadurch gekennzeichnet, daß** das Filtermodul (115) aufweist:

a) einen zweiten Operationsverstärker (OP4),

b) einen dritten Operationsverstärker (OP5),

c) ein erstes SC-Widerstandselement (405),

d) ein zweites SC-Widerstandselement (425),

e) ein drittes SC-Widerstandselement (440),

f) ein viertes SC-Widerstandselement (445),

g) eine erste Filterkapazität (420),

h) eine zweite Filterkapazität (430),

i) eine dritte Filterkapazität (435),

j) wobei der nicht-invertierende Eingang des zweiten Operationsverstärkers (OP4) sowie der nicht-invertierende Eingang des dritten Operationsverstärkers (OP5) auf einem Bezugspotential liegen,

k) wobei der Eingang des Filtermoduls (115) über das erste SC-Widerstandselement (425) mit dem invertierenden Eingang des zweiten Operationsverstärkers (OP4) verbunden ist,

l) wobei der Ausgang des Filtermoduls (115) mit dem Ausgang des dritten Operationsverstärkers (OP5) verbunden ist,

m) wobei der invertierende Eingang des dritten Operationsverstärkers (OP5) über die zweite Filterkapazität (430) mit dem Eingang des Filtermoduls (115) verbunden ist,

n) wobei der Ausgang des zweiten Operationsverstärkers (OP4) über die erste Filterkapazität (420) mit dem invertierenden Eingang des zweiten Operationsverstärkers (OP4) verbunden ist,

o) wobei der Ausgang des zweiten Operationsverstärkers (OP4) über das zweite SC-Widerstandselement (425) mit dem invertierenden Eingang des dritten Operationsverstärkers (OP5) verbunden ist,

p) wobei der invertierende Eingang des dritten Operationsverstärkers (OP5) über das dritte SC-Widerstandselement (440) mit dem Ausgang des dritten Operationsverstärkers (OP5) verbunden ist,

q) wobei der invertierende Eingang des zweiten Operationsverstärkers (OP4) über das vierte SC-Widerstandselement (445) mit dem Ausgang des dritten Operationsverstärkers (OP5) verbunden ist, und wobei

r) der invertierende Eingang des dritten Operationsverstärkers (OP5) über die dritte Filterkapazität (435) mit dem Ausgang des dritten Operationsverstärkers (OP5) verbunden ist.

11. SC-Filter nach Anspruch 10, **dadurch gekennzeichnet, daß** die Anti-Alias-Tiefpaßfiltereinheit (120) mit dem Biquad-Filter (115) zusammengelegt ist.

12. SC-Filter nach Anspruch 11, **gekennzeichnet durch**

a) einen ersten Anti-Alias-Tiefpaß mit einem ersten Tiefpaß-Widerstand (410) und einem ersten Tiefpaß-Kondensator (415),

b) einen zweiten Anti-Alias-Tiefpaß mit einem zweiten Tiefpaß-Widerstand (450) und einem zweiten Tiefpaß-Kondensator (455),

c) wobei der erste Tiefpaß-Widerstand (410) zwischen den Eingang des Filtermoduls (115) und dem ersten SC-Widerstandselement (405) eingefügt ist,

d) wobei der erste Tiefpaß-Kondensator (415) mit seinem ersten Anschluß an den Verbindungsknoten des ersten Tiefpaß-Widerstandes (410) und des ersten SC-Widerstandselementes (405) geschaltet ist und mit seinem zweiten Anschluß auf Bezugspotential gelegt ist,

e) wobei der zweite Tiefpaß-Widerstand (450) zwischen den auf den Ausgang des dritten Operationsverstärkers (OP5) gerichteten Anschluß des dritten SC-Widerstandselementes (440) und den auf den Ausgang des dritten Operationsverstärkers (OP5) gerichteten Anschluß der dritten Filterkapazität (435) eingefügt ist, und

f) wobei der zweite Tiefpaß-Kondensator (455) mit seinem ersten Anschluß an den Verbindungsknoten des zweiten Tiefpaß-Widerstandes (450) und des dritten SC-Widerstandselementes (440) geschaltet ist und mit seinem zweiten Anschluß auf Bezugspotential gelegt ist.

13. SC-Filter nach einem der Ansprüche 1 bis 8, **dadurch gekennzeichnet, daß** das Filtermodul (115) einen Tiefpaß zweiter Ordnung aufweist.

14. SC-Filter nach einem der Ansprüche 1 bis 8, **dadurch gekennzeichnet, daß** das Filtermodul (115) aufweist:

a) eine erste, zweite und dritte Kapazität (505, 515 bzw. 525),

b) einen ersten und einen zweiten Widerstand (510 bzw. 520),

c) ein SC-Widerstandselement (530),

d) wobei der Eingang (IN) des Filtermoduls (115) über die erste Kapazität (505) mit dem Ausgang (OUT) des Filtermoduls (115) verbunden ist,

e) wobei der Eingang (IN) des Filtermoduls (115) über den ersten Widerstand (510) und die zweite Kapazität (515) mit dem Bezugspotential verbunden ist,

f) wobei der Ausgang (OUT) des Filtermoduls (115) über den zweiten Widerstand (520) und die dritte Kapazität (525) mit dem Bezugspotential verbunden sind,

g) wobei der Schaltungsknoten zwischen dem ersten Widerstand (510) und der zweiten Kapazität (515) über das SC-Widerstandselement (530) mit dem Schaltungsknoten zwischen dem zweiten Widerstand (520) und der dritten Kapazität (525) verbunden ist.

15. SC-Filter nach Anspruch 14, **dadurch gekennzeichnet, daß** das SC-Widerstandselement (530) einen geschalteten Kondensator (540), eine erste Schalteinrichtung (545) und eine zweite Schalteinrichtung (550) aufweist, wobei die erste Schalteinrichtung (545) im leitenden Zustand den geschalteten Kondensator (540) entlädt und wobei die zweite Schalteinrichtung (550) im nichtleitenden Zustand einen Anschluß des geschalteten Kondensators (540) elektrisch von der Umgebung trennt.

16. SC-Filter nach Anspruch 1 bis 8, **dadurch gekennzeichnet, daß** das Filtermodul (115) aufweist:

a) einen zweiten Operationsverstärker (OP2),

b) einen dritten Operationsverstärker (OP3),

c) ein erstes SC-Widerstandselement (310),

d) ein zweites SC-Widerstandselement (325),
e) ein drittes SC-Widerstandselement (335),
f) ein viertes SC-Widerstandselement (340),
g) eine erste Filterkapazität (320),
h) eine zweite Filterkapazität (330),
i) wobei der nicht-invertierende Eingang des zweiten Operationsverstärkers (OP2) und der nicht-invertierende Eingang des dritten Operationsverstärkers (OP3) auf einem Bezugspotential liegen,
j) wobei der Eingang (IN) des Filtermoduls (115) über das erste SC-Widerstandselement (310) mit dem invertierenden Eingang des zweiten Operationsverstärkers (OP2) verbunden ist,
k) wobei der Ausgang des zweiten Operationsverstärkers (OP2) über das zweite SC-Widerstandselement (325) mit dem invertierenden Eingang des dritten Operationsverstärkers (OP3) verbunden ist,
l) wobei der Ausgang (OUT) des dritten Operationsverstärkers (OP3) mit dem Ausgang des Filtermoduls (115) verbunden ist,
m) wobei der Ausgang des zweiten Operationsverstärkers (OP2) über die erste Filterkapazität (320) mit dem invertierenden Eingang des zweiten Operationsverstärkers (OP2) verbunden ist,
n) wobei der Ausgang des dritten Operationsverstärkers (OP3) über die zweite Filterkapazität (330) mit dem invertierenden Eingang des dritten Operationsverstärkers (OP3) verbunden ist,
o) wobei der Ausgang des dritten Operationsverstärkers (OP3) über das dritte SC-Widerstandselement (335) mit dem invertierenden Eingang des dritten Operationsverstärkers (OP3) verbunden ist, und wobei
p) der Ausgang des dritten Operationsverstärkers (OP3) über das vierte SC-Widerstandselement (340) mit dem invertierenden Eingang des zweiten Operationsverstärkers (OP2) verbunden ist.

17. Audiosignalprozessor mit

a) mindestens einem Audiosignal-Eingang und mindestens einem Audiosignal-Ausgang sowie mindestens einem Steuereingang, und
b) einer zwischen Audiosignal-Eingang und Audiosignal-Ausgang geschalteten Audiosignalverarbeitungseinheit,
**dadurch gekennzeichnet, daß**
c) die Audiosignalverarbeitungseinheit mindestens ein SC-Filter gemäß einem der Ansprüche 1 bis 16 aufweist.

18. Audiosignalprozessor nach Anspruch 17, **gekenn-**

**zeichnet durch**

a) eine mit einer Datensammelleitung verbindbaren digitalen Steuereinheit,
b) wobei die digitale Steuereinheit die Einstellung des ohmschen Spannungsteilers (105) bestimmt.

**Claims**

1. An SC filter for adjustably decreasing or increasing the amplitude of audio signals in a predetermined frequency range, comprising

a) a filter module (115), said filter module having an RC network with at least one frequency-response-determining RC member whose resistor component R is realized in SC technology,
b) a setting means (110) connected to the filter module (115) such that its setting determines the frequency response of the SC filter,
c) said setting means (110) rendering possible in particular also a neutral setting in which the effective audio signal path of the SC filter circumvents the filter module (115) so that no decrease or increase of the amplitude of individual frequency portions takes place,
**characterized by**
d) an anti-alias low pass filter unit (120) connected into the audio signal path,
e) said anti-alias low pass filter unit (120) being not located in the audio - signal path when the setting means (110) is set to the neutral setting.

2. The SC filter of claim 1, **characterized in that** the setting means (110) is an ohmic voltage divider.

3. The SC filter of claim 2, **characterized in that** the setting means (110) comprises a potentiometer.

4. The SC filter of claim 2, **characterized in that** the setting means (110) is provided with a voltage divider having one or more transistors.

5. The SC filter of any one of claims 2, 3 or 4, **characterized in that** the filter module (115) and the anti-alias low pass filter unit (120) are connected in series and the overall resistor of ohmic voltage divider (110) is connected in parallel to the series connection of filter module (115) and anti-alias low pass filter unit (120).

6. The SC filter of claim 5,

**characterized by**

a) a first operational amplifier (OP1),
b) with the tap (105) of ohmic voltage divider (110) being connected to the inverting input of first operational amplifier (OP1) and
c) the input of anti-alias low pass filter unit (120) being connected to the output of first operational amplifier (OP1).

7. The SC filter of any of claims 1 to 6, comprising

a) an input (IN) and an output (OUT),
b) a first operational amplifier (OP1), with the non-inverting input of first operational amplifier (OP1) being connected to input (IN) and the output of first operational amplifier (OP1) being connected to output (OUT),
c) an ohmic voltage divider (110) whose tap (105) is connected to the inverting input of first operational amplifier (OP1),
d) with the output of first operational amplifier (OP1) being connected to the input of anti-alias low pass filter unit (120) as well as to a first end terminal of ohmic voltage divider (110),
e)
f) g) with the output of anti-alias low pass filter unit (120) being connected to the input of filter module (115), and
h) with the output of filter module (115) being connected to a second end terminal of ohmic voltage divider (110).

8. The SC filter of any one of the preceding claims, **characterized in that** the anti-alias low pass filter unit (120) is an RC low - pass.

9. The SC filter of any one of the preceding claims, **characterized in that** the filter module (115) comprises a biquad filter.

10. The SC filter of claim 9, **characterized in that** filter module (115) comprises:

a) a second operational amplifier (OP4),
b) a third operational amplifier (OP5),
c) a first SC resistor member (405),
d) a second SC resistor member (425),
e) a third SC resistor member (440),
f) a fourth SC resistor member (445),
g) a first filter capacitor (420),
h) a second filter capacitor (430),
i) a third filter capacitor (435),
j) the non-inverting input of second operational amplifier (OP4) and the non-inverting input of third operational amplifier (OP5) being at a reference potential,

k) the input of filter module (115) being connected via first SC resistor member (425) to the inverting input of second operational amplifier (OP4),
l) the output of filter module (115) being connected to the output of third operational amplifier (OP5),
m) the inverting input of third operational amplifier (OP5) being connected via second filter capacitor (430) to the input of filter module (115),
n) the output of second operational amplifier (OP4) being connected via first filter capacitor (420) to the inverting input of second operational amplifier (OP4),
o) the output of second operational amplifier (OP4) being connected via second SC resistor member (425) to the inverting input of third operational amplifier (OP5),
p) the inverting input of third operational amplifier (OP5) being connected via third SC resistor member (440) to the output of third operational amplifier (OP5),
q) the inverting input of second operational amplifier (OP4) being connected via fourth SC resistor member (445) to the output of third operational amplifier (OP5), and
r) the inverting input of third operational amplifier (OP5) being connected via third filter capacitor (435) to the output of the third operational amplifier (OP5).

11. The SC filter of claim 10, **characterized in that** the anti-alias low pass filter unit (120) is combined with the biquad filter (115).

12. The SC filter of claim 11, **characterized by**

a) a first anti-alias low pass having a first low pass resistor (410) and a first low pass capacitor (415),
b) a second anti-alias low pass having a second low pass resistor (450) and a second low pass capacitor (455),
c) the first low pass resistor (410) being inserted between the input of filter module (115) and the first SC resistor member (405),
d) the first low pass capacitor (415) having its first terminal connected to the connecting node of the first low pass resistor (410) and of the first SC resistor member (405) and having its second terminal connected to reference potential,
e) the second low pass resistor (450) being inserted between the terminal of the third SC resistor member (440) that is directed towards the output of third operational amplifier (OP5) and the terminal of the third filter capacitor (435) that is directed towards the output of third operational amplifier (OP5), and

f) the second low pass capacitor (455) having its first terminal connected to the connecting node of the second low pass resistor (450) and of the third SC resistor member (440) and having its second terminal connected to reference potential.

13. The SC filter of any one of claims 1 to 8, **characterized in that** the filter module (115) comprises a low pass of the second order.

14. The SC filter of any one of claims 1 to 8, **characterized in that** the filter module (115) comprises:

a) first, second and third capacitors (505, 515 and 525, respectively),
b) first and second resistors (510 and 520, respectively),
c) an SC resistor member (530),
d) the input (IN) of filter module (115) being connected via first capacitor (505) to the output (OUT) of filter module (115),
e) the input (IN) of filter module (115) being connected via first resistor (510) and second capacitor (515) to the reference potential,
f) the output (OUT) of filter module (115) being connected via second resistor (520) and third capacitor (525) to the reference potential,
g) the circuit node between first resistor (510) and second capacitor (515) being connected via SC resistor member (530) to the circuit node between second resistor (520) and third capacitor (525).

15. The SC filter of claim 14, **characterized in that** the SC resistor member (530) comprises a switched capacitor (540), a first switching means (545) and a second switching means (550), the first switching means (545), in the conducting state, discharging the switched capacitor (540), and the second switching means (550), in the non-conducting state, electrically separating a terminal of the switched capacitor (540) from the surroundings.

16. The SC filter of claims 1 to 8, **characterized in that** the filter module (115) comprises:

a) a second operational amplifier (OP2),
b) a third operational amplifier (OP3),
c) a first SC resistor member (310),
d) a second SC resistor member (325),
e) a third SC resistor member (335),

f) a fourth SC resistor member (340),
g) a first filter capacitor (320),
h) a second filter capacitor (330),
i) the non-inverting input of second operational amplifier (OP2) and the non-inverting input of third operational amplifier (OP3) being at a reference potential,
j) the input (IN) of filter module (115) being connected via first SC resistor member (310) to the inverting input of second operational amplifier (OP2),
k) the output of second operational amplifier (OP2) being connected via second SC resistor member (325) to the inverting input of third operational amplifier (OP3),
l) the output (OUT) of third operational amplifier (OP3) being connected to the output of filter module (115),
m) the output of second operational amplifier (OP2) being connected via first filter capacitor (320) to the inverting input of second operational amplifier (OP2),
n) the output of third operational amplifier (OP3) being connected via second filter capacitor (330) to the inverting input of third operational amplifier (OP3),
o) the output of third operational amplifier (OP3) being connected via third SC resistor member (335) to the inverting input of third operational amplifier (OP3), and
p) the output of third operational amplifier (OP3) being connected via fourth SC resistor member (340) to the inverting input of second operational amplifier (OP2).

17. An audio signal processor comprising

a) at least one audio signal input and at least one audio signal output as well as at least one control input, and
b) an audio signal processing unit connected between audio signal input and audio signal output,
**characterized in that**
c) the audio signal processing unit comprises at least one SC filter according to any one of claims 1 to 16.

18. The audio signal processor of claim 17, **characterized by**

a) a digital control unit connectable to a data bus line,
b) said digital control unit determining the setting of said ohmic voltage divider (105).

**Revendications**

1. Filtre à capacités commutées pour l'abaissement ou l'élévation réglable de l'amplitude de signaux audio dans une plage de fréquences prédéfinie,

   a) avec un module de filtre (115), le module de filtre présentant un réseau RC avec au moins un élément RC déterminant la réponse en fréquence, dont la composante de résistance R est réalisée dans la technique à capacités commutées,

   b) avec un appareil de réglage (110) qui est branché avec le module de filtre (115) de telle sorte que son réglage définit la réponse en fréquence du filtre à capacités commutées,

   c) l'appareil de réglage (110) permettant en particulier également un réglage neutre dans lequel le chemin efficace du signal audio du filtre à capacités commutées contourne le module de filtre (115), de sorte qu'on n'a pas d'abaissement ou d'élévation de l'amplitude de plages de fréquences individuelles,
   **caractérisé par**

   d) une unité de filtre passe-bas antirepliement (120) commutée dans le chemin du signal audio,

   e) l'unité de filtre passe-bas antirepliement (120) n'étant pas située dans le chemin du signal audio lorsque l'appareil de réglage (110) est réglé dans la position neutre.

2. Filtre à capacités commutées selon la revendication 1, **caractérisé en ce que** l'appareil de réglage (110) est un diviseur de tension ohmique.

3. Filtre à capacités commutées selon la revendication 2, **caractérisé en ce que** l'appareil de réglage (110) présente un potentiomètre.

4. Filtre à capacités commutées selon la revendication 2, **caractérisé en ce que** l'appareil de réglage (110) est doté d'un diviseur de tension présentant un ou plusieurs transistors.

5. Filtre à capacités commutées selon l'une des revendications 2, 3 ou 4, **caractérisé en ce que** le module de filtre (115) et l'unité de filtre passe-bas antirepliement (120) sont branchés en série et la résistance globale du diviseur de tension (110) ohmique est branchée parallèlement au montage en série du module de filtre (115) et de l'unité de filtre passe-bas antirepliement (120).

6. Filtre à capacités commutées selon la revendication 5, **caractérisé par**

   a) un premier amplificateur opérationnel (OP1),

   b) le prélèvement (105) du diviseur de tension (110) ohmique étant relié à l'entrée inversante du premier amplificateur opérationnel (OP1) et

   c) l'entrée de l'unité de filtre passe-bas antirepliement (120) étant reliée à la sortie du premier amplificateur opérationnel (OP1).

7. Filtre à capacités commutées selon l'une des revendications 1 à 6,

   a) avec une entrée (IN) et une sortie (OUT),

   b) avec un premier amplificateur opérationnel (OP1), l'entrée non inversante du premier amplificateur opérationnel (OP1) étant reliée à l'entrée (IN) et la sortie du premier amplificateur opérationnel (OP1) à la sortie (OUT),

   c) avec un diviseur de tension (110) ohmique, dont le prélèvement (105) est relié à l'entrée inversante du premier amplificateur opérationnel (OP1),

   d) la sortie du premier amplificateur opérationnel (OP1) étant reliée à l'entrée de l'unité de filtre passe-bas antirepliement (120) et à un premier branchement d'extrémité du diviseur de tension (110) ohmique,

   e) la sortie de l'unité de filtre passe-bas antirepliement (120) étant reliée à l'entrée du module de filtre (115), et

   f) la sortie du module de filtre (115) étant reliée à un second branchement d'extrémité du diviseur de tension (110) ohmique.

8. Filtre à capacités commutées selon l'une des revendications précédentes, **caractérisé en ce que** l'unité de filtre passe-bas antirepliement (120) est un filtre passe-bas RC.

9. Filtre à capacités commutées selon l'une des revendications précédentes, **caractérisé en ce que** le module de filtre (115) est un filtre Biquad.

10. Filtre à capacités commutées selon la revendication 9, **caractérisé en ce que** le module de filtre (115) présente :

    a) un second amplificateur opérationnel (OP4),

b) un troisième amplificateur opérationnel (OP5),

c) un premier élément de résistance à capacités commutées (405),

d) un second élément de résistance à capacités commutées (425),

e) un troisième élément de résistance à capacités commutées (440),

f) un quatrième élément de résistance à capacités commutées (445),

g) une première capacité de filtre (420),

h) une seconde capacité de filtre (430),

i) une troisième capacité de filtre (435),

j) l'entrée non inversante du second amplificateur opérationnel (OP4) et l'entrée non inversante du troisième amplificateur opérationnel (OP5) étant disposées sur un potentiel de référence,

k) l'entrée du module de filtre (115) étant reliée par le premier élément de résistance à capacités commutées (425) à l'entrée inversante du second amplificateur opérationnel (OP4),

l) la sortie du module de filtre (115) étant reliée à la sortie du troisième amplificateur opérationnel (OP5),

m) l'entrée inversante du troisième amplificateur opérationnel (OP5) étant reliée par la seconde capacité de filtre (430) à l'entrée du module de filtre (115),

n) la sortie du second amplificateur opérationnel (OP4) étant reliée par la première capacité de filtre (420) à l'entrée inversante du second amplificateur opérationnel (OP4),

o) la sortie du second amplificateur opérationnel (OP4) étant reliée par le second élément de résistance à capacités commutées (425) à l'entrée inversante du troisième amplificateur opérationnel (OP5),

p) l'entrée inversante du troisième amplificateur opérationnel (OP5) étant reliée par le troisième élément de résistance à capacités commutées (440) à la sortie du troisième amplificateur opérationnel (OP5),

q) l'entrée inversante du second amplificateur opérationnel (OP4) étant reliée par le quatrième élément de résistance à capacités commutées (445) à la sortie du troisième amplificateur opérationnel (OP5), et

r) l'entrée inversante du troisième amplificateur opérationnel (OP5) étant reliée par la troisième capacité de filtre (435) à la sortie du troisième amplificateur opérationnel (OP5).

11. Filtre à capacités commutées selon la revendication 10, **caractérisé en ce que** l'unité de filtre passe-bas antirepliement (120) est assemblée avec le filtre Biquad (115).

12. Filtre à capacités commutées selon la revendication 11, **caractérisé par**

a) un premier filtre passe-bas antirepliement avec une première résistance de filtre passe-bas (410) et un premier condensateur de filtre passe-bas (415),

b) un second filtre passe-bas antirepliement avec une seconde résistance de filtre passe-bas (450) et un second condensateur de filtre passe-bas (455),

c) la première résistance de filtre passe-bas (410) étant insérée entre l'entrée du module de filtre (115) et le premier élément de résistance à capacités commutées (405),

d) le premier condensateur de filtre passe-bas (415) étant commuté avec son premier branchement sur le noeud de liaison de la première résistance de filtre passe-bas (410) et du premier élément de résistance à capacités commutées (405) et étant placé avec son branchement sur le potentiel de référence,

e) la seconde résistance du filtre passe-bas (450) étant insérée entre le branchement, dirigé sur la sortie du troisième amplificateur opérationnel (OP5), du troisième élément de résistance à capacités commutées (440) et le branchement, dirigé sur la sortie du troisième amplificateur opérationnel (OP5), de la troisième capacité de filtre (435), et

f) le second condensateur de filtre passe-bas (455) étant commuté avec son premier branchement sur le noeud de liaison de la seconde résistance de filtre passe-bas (450) et du troisième élément de résistance à capacités commutées (440) et étant placé avec son second branchement sur le potentiel de référence.

**13.** Filtre à capacités commutées selon l'une des revendications 1 à 8, **caractérisé en ce que** le module de filtre (115) présente un filtre passe-bas de second ordre.

**14.** Filtre à capacités commutées selon l'une des revendications 1 à 8, **caractérisé en ce que** le module de filtre (115) présente :

a) une première, une seconde, une troisième capacités (505, 515 et 525),

b) une première et une seconde résistance (510 et 520),

c) un élément de résistance à capacités commutées (530),

d) l'entrée (IN) du module de filtre (115) étant reliée par la première capacité (505) à la sortie (OUT) du module de filtre (115),

e) l'entrée (IN) du module de filtre (115) étant reliée par la première résistance (510) et la seconde capacité (515) au potentiel de référence,

f) la sortie (OUT) du module de filtre (115) étant reliée par la seconde résistance (520) et la troisième capacité (525) au potentiel de référence,

g) le noeud de commutation étant relié entre la première résistance (510) et la seconde capacité (515) par l'élément de résistance à capacités commutées (530) au noeud de commutation entre la seconde résistance (520) et la troisième capacité (525).

**15.** Filtre à capacités commutées selon la revendication 14, **caractérisé en ce que** l'élément de résistance à capacités commutées (530) présente un condensateur (540) commuté, un premier dispositif de commutation (545) et un second dispositif de commutation (550), le premier dispositif de commutation (545) déchargeant le condensateur (540) commuté dans l'état conducteur et le second dispositif de commutation (550) séparant électriquement dans l'état non-conducteur un branchement du condensateur (540) commuté de l'environnement.

**16.** Filtre à capacités commutées selon les revendications 1 à 8, **caractérisé en ce que** le module de filtre (115) présente :

a) un second amplificateur opérationnel (OP2),

b) un troisième amplificateur opérationnel (OP3),

c) un premier élément de résistance à capacités commutées (310),

d) un second élément de résistance à capacités commutées (325),

e) un troisième élément de résistance à capacités commutées (335),

f) un quatrième élément de résistance à capacités commutées (340),

g) une première capacité de filtre (320),

h) une seconde capacité de filtre (330),

i) l'entrée non inversante du second amplificateur opérationnel (OP2) et l'entrée non inversante du troisième amplificateur opérationnel (OP3) étant disposées sur un potentiel de référence,

j) l'entrée (IN) du module de filtre (115) étant reliée par le premier élément de résistance à capacités commutées (310) à l'entrée inversante du second amplificateur opérationnel (OP2),

k) la sortie du second amplificateur opérationnel (OP2) étant reliée par le second élément de résistance à capacités commutées (325) à l'entrée inversante du troisième amplificateur opérationnel (OP3),

l) la sortie (OUT) du troisième amplificateur opérationnel (OP3) étant reliée à la sortie du module de filtre (115),

m) la sortie du second amplificateur opérationnel (OP2) étant reliée par la première capacité de filtre (320) à l'entrée inversante du second amplificateur opérationnel (OP2),

n) la sortie du troisième amplificateur opérationnel (OP3) étant reliée par la seconde capacité de filtre (330) à l'entrée inversante du troisième amplificateur opérationnel (OP3),

o) la sortie du troisième amplificateur opérationnel (OP3) étant reliée par le troisième élément de résistance à capacités commutées (335) à l'entrée inversante du troisième amplificateur opérationnel (OP3), et

p) la sortie du troisième amplificateur opérationnel (OP3) étant reliée par le quatrième élément de résistance à capacités commutées (340) à l'entrée inversante du second amplificateur opérationnel (OP2).

**17.** Processeur de signal audio avec

a) au moins une entrée de signal audio et au moins une sortie de signal audio ainsi qu'au moins une entrée de commande, et
b) une unité de traitement de signal audio branchée entre l'entrée du signal audio et la sortie du signal audio,
**caractérisé en ce que**
c) l'unité de traitement de signal audio présente au moins un filtre à capacités commutées selon l'une des revendications 1 à 16.

**18.** Processeur de signal audio selon la revendication 17, **caractérisé par**

a) une unité de commande numérique pouvant être reliée à une ligne collectrice de données,
b) l'unité de commande numérique déterminant le réglage du diviseur de tension (105) ohmique.

FIG.1

EP 0 821 483 B1

200

IN ⸻⊣⊢⸻ OUT    FIG.2a

210

$S_1$    $\Phi_1$    $\Phi_1$

IN ⸻ $\Phi_2$ ⊣⊢ $\Phi_2$ ⸻ OUT    FIG.2b

$S_2$

FIG. 2c

FIG.2d

# FIG.3

EP 0 821 483 B1

FIG.4

EP 0 821 483 B1

FIG.5

500

505

510

515

520

525

540

545

550

IN

OUT

# FIG.6

HOCHFREQENZ-
PROZESSOR
RFP

NF-Signal

ASP
AUDIO-
SIGNAL-
PROZES-
SOR

APP
LEISTUNGS-
VERSTÄRKER

MICRO-
CON
TROLLER

I²C

I²C

Analoge
Eingänge

I²C

STROMVER-
SORGUNG

AUDIO-LEISTUNGS-
PROZESSOR

BEDIEN-
EINHEIT

EP 0 821 483 B1

# FIG.7

FSP

CD 50i 50j

50h
50g

50a
50b
50c
50d
50e
50f

ANALOG-
MULTI-
PLEXER
(MUX)

57a
57b

60 62 64

MUTE | LAUT-ST.-R | SOFT MUTE | BASS 66 | HÖHEN

68 70

90 PAUSE

STEUERUNG I$^2$C-BUS

XTAL

PLL 72 456kHz

STROM-VERS.

80kHz TP 73

140kHz HP

120kHz HP

PEAK-D.

DEMODULATOR+ PILOTTRÄGER 75

26kHz TP 79

SPIKE FILT.

HIGH CUT

PULSE

PEGEL-STEUERUNG

95 74 76 77 78 80 81 82

EP 0 821 483 B1